(19) Europäisches Patentamt
European Patent Office
Office européen des brevets

(11) **EP 1 683 254 B1**

(12) **EUROPÄISCHE PATENTSCHRIFT**

(45) Veröffentlichungstag und Bekanntmachung des Hinweises auf die Patenterteilung:
**15.04.2009 Patentblatt 2009/16**

(21) Anmeldenummer: **04798177.4**

(22) Anmeldetag: **08.11.2004**

(51) Int Cl.:
***H02M 3/335*** *(2006.01)*

(86) Internationale Anmeldenummer:
**PCT/EP2004/052858**

(87) Internationale Veröffentlichungsnummer:
**WO 2005/048440 (26.05.2005 Gazette 2005/21)**

(54) **SPANNUNGSWANDLER UND VERFAHREN ZUM BETREIBEN EINES SPANNUNGSWANDLERS**

VOLTAGE TRANSFORMER AND METHOD FOR OPERATING A VOLTAGE TRANSFORMER

TRANSFORMATEUR DE TENSION ET PROCEDE DE FONCTIONNEMENT ASSOCIE

(84) Benannte Vertragsstaaten:
**DE FR**

(30) Priorität: **13.11.2003 DE 10353037**

(43) Veröffentlichungstag der Anmeldung:
**26.07.2006 Patentblatt 2006/30**

(73) Patentinhaber: **Continental Automotive GmbH**
**30165 Hannover (DE)**

(72) Erfinder:
• **AUGESKY, Christian, Georg**
**93055 Regensburg (DE)**
• **GÖTZENBERGER, Martin**
**85051 Ingolstadt (DE)**

(56) Entgegenhaltungen:
**US-A- 5 097 196      US-A- 5 594 635**
**US-A- 5 917 722**

• **WANG S ET AL: "INDUCTION-HEATED COOKING APPLIANCE USING NEW QUASI-RESONANT ZVS-PWM INVERTER WITH POWER FACTOR CORRECTION" IEEE TRANSACTIONS ON INDUSTRY APPLICATIONS, IEEE INC. NEW YORK, US, Bd. 34, Nr. 4, Juli 1998 (1998-07), Seiten 705-712, XP000848008 ISSN: 0093-9994**

**Beschreibung**

Die Erfindung betrifft einen Spannungswandler und ein Verfahren zum Betreiben eines Spannungswandlers, insbesondere einer Schaltungsanordnung zum Ansteuern einer kapazitiven Last, beispielsweise eines piezoelektrischen Aktors für ein Einspritzventil einer Brennkraftmaschine.

Bei getakteten Spannungswandlern wird eine Gleichspannung mit Halbleiterschaltern in eine pulsierende Gleichspannung zerteilt. Diese pulsierende Gleichspannung kann mit Hilfe eines Energiespeichers, wie beispielsweise eines Kondensators, einer Drosselspule oder auch eines Transformators in eine kleinere oder größere Spannung umgeformt werden. Zur Steuerung oder Regelung der Ausgangsspannung wird das Verfahren der Pulsbreitenmodulation verwendet. Dabei wird die Eingangsspannung periodisch unterbrochen und mit variabler Pulsbreite wieder eingeschaltet. Auf diese Weise können Stromversorgungen mit einem im Vergleich zu Linearreglern größeren Wirkungsgrad geschaffen werden.

Solche getakteten Spannungsregler werden auch zur Ansteuerung von piezoelektrischen Aktoren, wie sie in Kraftstoffinjektoren moderner Brennkraftmaschinen Verwendung finden. In diesem Anwendungsfall werden hohe Anforderungen an die Ansteuerschaltung gestellt. So müssen hohe Spannungen in einem Bereich von mehreren 100 Volt und hohe Ströme zum Laden und Entladen des piezoelektrischen Aktors zur Verfügung gestellt werden. Neben sehr kurzen Lade- und Entladezeiten, die im Bereich von weniger als einer Millisekunden liegen, werden ebenfalls hohe Anforderung an eine exakte und reproduzierbare Ansteuerung des Aktors gestellt. Um zukünftige Abgasemissionsgrenzwerte einhalten zu können, erhöht sich die Anzahl der Kraftstoffeinspritzungen pro Verbrennungstakt. Dadurch werden die Einspritzzeiten und somit auch die Ansteuerzeiten für den piezoelektrischen Aktor immer kürzer, was zusätzliche Anforderungen an die Ansteuerschaltung des Aktors stellt.

Bei einer bekannten Schaltungsanordnung (DE 199 44 733 A1) wird ein piezoelektrischer Aktor von einem Ladekondensator über einen Transformator geladen, in dem ein auf der Primärseite des Transformators angeordneter Ladeschalter mit einem pulsweiten modulierten Steuersignal angesteuert wird. Der Lade- und auch der Entladeschalter sind als steuerbare Halbleiterschalter ausgeführt. Die Stellgliedspannung am piezoelektrischen Aktor wird dort durch ein pulsweitenmoduliertes Ansteuern des Ladeschalters eingestellt.

Die beim Schalten des Halbleiterschalters frei werdende Verlustleistung hängt zum einen von der über dem Halbleiterschalter abfallenden Spannung und zum anderen von der Schaltfrequenz ab, mit der dieser angesteuert wird.

Die Höhe der Schaltverluste beschränkt dadurch auch die Höhe der Schaltfrequenz, da pro Schaltvorgang ein gewisser Energiebetrag in Verlustleistung umgesetzt wird. Weiter wird beim Schalten unter Last, dem sog. "harten" Schalten und der damit verbundenen schnellen Schaltflanken auch ein breites Spektrum an Störfrequenzen erzeugt. Wodurch die Elektromagnetische-Verträglichkeit (EMV) der Schaltungsanordnung negativ beeinflusst wird

Aufgrund der so begrenzten Schaltfrequenz wird ebenfalls eine Miniaturisierung der Schaltungsanordnung beschränkt, da einerseits die Energiespeicherkapazität und somit auch die Baugröße der energiespeichernden Bauteile, wie beispielsweise die von Spulen oder Kondensatoren, proportional zu der Schaltfrequenz ist und andererseits aufgrund der erzeugten Verlustleistung eine ausreichende Wärmeableitung im Bereich der Halbleiterschalter sichergestellt werden muss.

Das sog. "harte" Schalten ohne Schalterleichterung macht jedoch weitere Maßnahmen zur Sicherstellung der elektromagnetischen Verträglichkeit (EMV) des Schaltwandlers erforderlich. Hierdurch werden zusätzliche Verluste erzeugt.

Aus der Literatur sind sog. resonante Schalter bekannt (bspw. Muhammad H. Rashid, Power Electronics Circuits, Devices and Applications; Third Edition, Pearson Education, 2004). Bei einem resonanten Schalter, über dem beim Schalten eine Spannung von Null Volt abfallen soll, wird ein Kondensator parallel geschaltet. Bei einem Spannungswandler mit einem solchen resonanten Schalter müssen jedoch beim Schalten bestimmte Spannungsverhältnisse zwischen Ein- und Ausgangsspannung eingehalten werden, um ein resonantes Umschwingen zu ermöglichen. Wird dieses Spannungsverhältnis beim Schalten nicht eingehalten, so erfolgt das Schalten wieder "hart", d.h. unter Last.

US 5 594 635 offenbart auch einen Spannungswandler mit

Resonanzumladungsvorgänge, um die elektrische Verlustleistung zu reduzieren.

Aufgabe der Erfindung ist es daher einen Spannungswandler und ein Verfahren zum Betreiben eines Spannungswandlers zu schaffen, die hinsichtlich der beim Betrieb auftretenden Verlustleistung und der elektromagnetischen Verträglichkeit optimiert sind.

Diese Aufgabe wird erfindungsgemäß durch einen Spannungswandler mit den Merkmalen des Patentanspruchs 1.

Der Spannungswandler weist einen ersten und einen zweiten Halbleiterschalter, eine Induktivität und einen parallel zu einem der beiden Schalter angeordneten Umschwingenergiespeicher auf. Dieser Umschwingenergiespeicher ist so ausgelegt, dass bei einem Schaltvorgang dieser abgeschlossen ist, bevor der Umschwingenergiespeicher vollständig entladen ist. Dadurch wird die über den Schaltern beim Schalten abfallende durch wird die über den Schaltern beim Schalten abfallende Spannung soweit verringert, dass die Schaltverluste der Schaltungsanordnung reduziert werden und dadurch auch die Störausstrahlung und Störleitung der Spannungswandlers erheblich vermindert wird.

Bei dem Verfahren zum Betreiben des Spannungswandlers wird die Ausgangsspannung und/ oder die Eingangsspannung des Spannungswandlers von einer Steuereinheit überwacht und in Abhängigkeit von diesen Spannungen oder auch dem Verhältnis dieser Spannungen der Induktivität des Spannungswandlers durch einen Vorladestrom Energie zugeführt. Dieses Vorladen erfolgt durch geeignete Steuerung der Schalter durch die Steuereinheit. Hierdurch wird verhindert, dass bei bestimmten Betriebsbedingungen ein hoher Spannungspuls beim Ein- und/ oder Ausschalten eines Schalters entsteht. Das Prinzip der Vorladung der Speicherinduktivität eignet sich sowohl für die Abwärts- als auch für die Aufwärtswandlung einer Spannung.

Bei dem Umschwingenergiespeicher handelt es sich vorzugsweise um einen Umschwingkondensator, der so ausgelegt ist, dass die Entladezeitdauer des Kondensators größer ist, als die Schaltdauer des Halbleiterschalters. In einer besonders bevorzugten Ausführungsform entspricht die Entladezeitdauer in etwa der dreifachen Schaltdauer der Halbleiterschalter.

Mit Hilfe der erfindungsgemäßen Schaltungsanordnung kann auch die Schaltfrequenz der Halbleiterschalter erhöht werden, ohne dass sich die Schaltverluste oder auch die Störausstrahlung auf ein Maß erhöhen, das wiederum Maßnahmen zur Kompensation dieser Störungen erforderlich machen würde. Somit können auch Komponenten, die zur Energiespeicherung dienen, wie beispielsweise Kondensatoren oder Induktivitäten, deren Energiespeicherkapazität umgekehrt proportional zu der Schaltfrequenz ist, in ihrer Baugröße reduziert werden, wodurch zusätzlich eine Verkleinerung der Baugröße der Schaltungsanordnung möglich ist.

Aufgrund der verringerten Schaltverluste erzeugt die Schaltungsanordnung somit weniger Verlustwärme. Daher kann auch die Größe einer Kühlanordnung zum Abführen der beim Betrieb freiwerdenden Verlustwärme reduziert werden.

Der oben beschriebene Einsatz eines Umschwingenergiespeichers eignet sich für eine Vielzahl von getakteten Spannungswandlern. So kann die erfindungsgemäße Schaltungsanordnung beispielsweise bei Durchfluss wandlern (Tiefsetzsteller, Hochsetzsteller und Hoch- und Tiefsetzsteller), Sperrwandlern (ebenfalls Hochsetzsteller, Tiefsetzsteller und Hoch- und Tiefsetzsteller) und anderen gängigen Schaltwandlern, wie beispielsweise einem Flyback-, einem SEPIC-, einem CUK- oder auch einem Wittenbreeder-Konverter zum Einsatz kommen. Solche Spannungswandler sind dem Fachmann allgemein bekannt.

Bei einer bevorzugten Ausführungsform ist der Spannungswandler als Hoch- und Tiefsetzsteller (Buck-Boost-Konverter) ausgeführt. Hierbei sind die beiden Schalter als Halbbrücke zwischen den Anschlüssen einer Versorgungsspannungsquelle angeordnet. Aufgrund einer für das Betreiben erforderlichen hohen Stromtragfähigkeit der Halbleiterschalter sind diese typischerweise als Leistungshalbleiterschalter, wie beispielsweise als Leistungs-MOS-Feldeffekttransistoren (MOSFETs) oder als Insulated-Gate-Bipolar-Transistoren (IGBTs) ausgebildet. Die Steueranschlüsse dieser Halbleiterschalter werden von der Steuerschaltung angesteuert.

Vorteilhafte Ausgestaltung und Weiterbildung der Erfindung sind in den Unteransprüchen, sowie der Beschreibung unter Bezugnahme auf die Zeichnungen entnehmbar.

Mehrere Ausführungsbeispiele der Erfindung werden im Folgenden anhand der schematischen Zeichnungen näher erläutert. Es zeigen:

| Figur 1 | ein Blockschaltbild einer Ansteuerschaltung für nen piezoelektrischen Aktor, der von einem erfindungsgemäßen Spannungswandler gesteuert wird, |
| --- | --- |
| Figur 2 | ein Ausführungsbeispiel eines erfindungsgemäßen Spannungswandlers, |
| Figur 3 | ein Ausführungsbeispiel eines Ablaufdiagramms, das die Schritte eines Verfahrens zum Ansteuern des Spannungswandlers wiedergibt, |
| Figur 4 a und b | den Verlauf der Spannung über einem Umschwingkondensator, sowie den Verlauf des Stroms durch eine Spule beim Auf- bzw. Entladen eines piezoelektrischen Aktors als Funktion der Zeit, und |
| Figur 5 a und b | den Verlauf der Spannung über dem Umschwingkondensator, sowie den Verlauf des Stroms durch die Induktivität und des Ladestroms des Unmschwingkondensators als Funktion der Zeit für eine Ausgangsspannung, die kleiner als die halbe Eingangsspannung ist, jeweils für zwei verschiedene Ladeverfahren. |

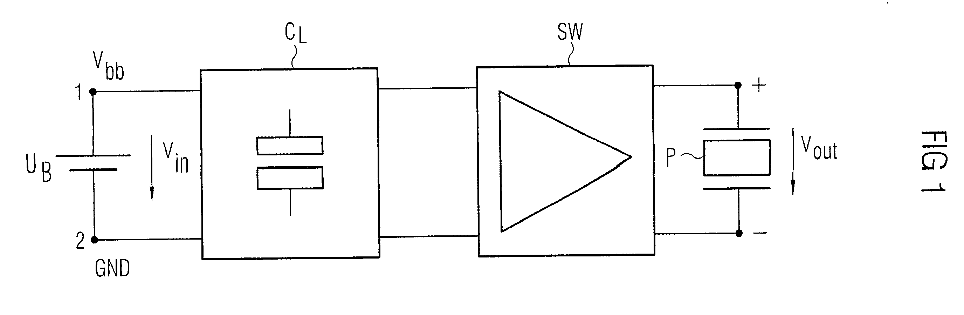

Figur 1 zeigt ein Blockschaltbild einer Ansteuerschaltung für eine kapazitive Last, hier einen piezoelektrischen Aktor P. Diese weist eine Versorgungsspannungsquelle $U_B$, einen Speicherkondensator $C_L$ und einen Spannungswandler SW auf. Die Versorgungsspannungsquelle weist zwei Anschlüsse 1, 2 auf, über die die Schaltungsanordnung mit einer Versorgungsspannung $V_{in}$ versorgt wird. Die Versorgungsspannungsquelle $U_B$ kann beispielsweise ein Gleichspannungswandler mit einer einstellbaren Ausgangsspannung $V_{in}$ von beispielsweise 200 Volt sein. Der erste Anschluss 1 der Versorgungsspannungsquelle $U_B$ weist ein erstes Potential VBB auf. Der zweite Anschluss 2 der Versorgungsspannungsquelle $U_B$ weist ein zweites Versorgungspotential GND, hier Masse auf.

Der Ladeenergiespeicher $C_L$ ist einerseits mit dem ersten Anschluss 1 und andererseits mit dem zweiten Anschluss 2 elektrisch verbunden. Der Spannungswandler SW ist eingangsseitig über den Ladeenergiespeicher $C_L$ mit dem ersten Anschluss 1 und dem zweiten Anschluss 2 elektrisch verbunden. Ausgangsseitig ist der Spannungswandler SW jeweils mit einem positiven + und einem negativen Anschluss - des piezoelektrischen Aktors P elektrisch verbunden.

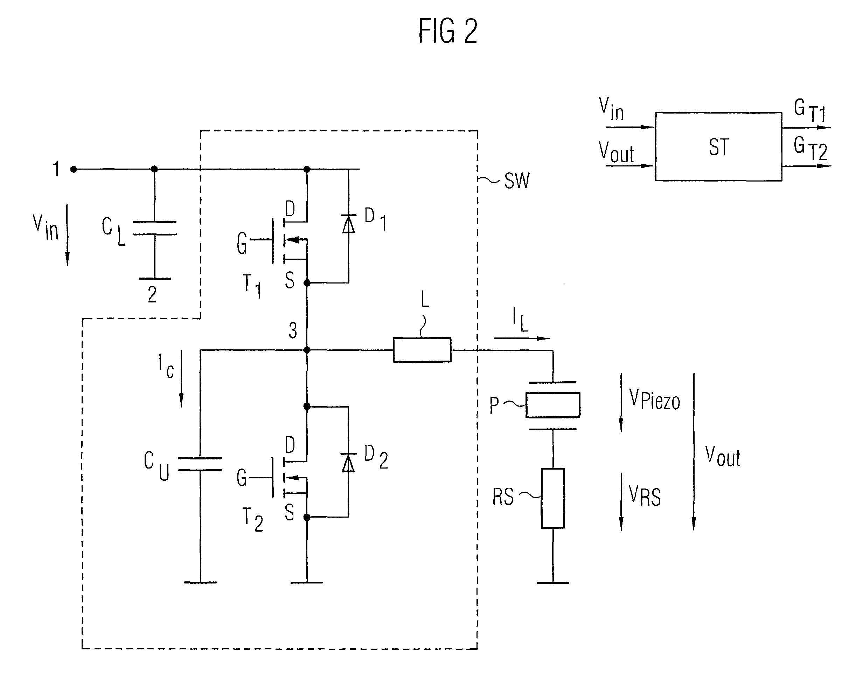

Figur 2 zeigt ein Ausführungsbeispiel eines Spannungswandlers SW, der entsprechend dem in Figur 1 aufgezeigten Blockschaltbild eingangsseitig mit dem Ladeenergiespeicher $C_L$ und über diesen mit der Versorgungsspannungsquelle $U_B$ elektrisch verbunden ist. Zwischen dem ersten Anschluss 1 und dem zweiten Anschluss 2 der Versorgungsspannungsquelle $U_B$ ist hier eine als Halbbrücke ausgebildete Serienschaltung zweier steuerbarer Schalter $T_1$ und $T_2$ angeordnet. Diese Schalter $T_1$ und $T_2$ sind vorteilhaft als Transistor, speziell als N-Kanal-MOSFET ausgebildet. Zwischen Source des ersten Schalters $T_1$ und Source des zweiten Schalters $T_2$ ist ein Mittelabgriff 3 angeordnet. Parallel zu diesen Schaltern $T_1$, $T_2$ ist jeweils eine Freilaufdiode $D_1$, $D_2$ angeordnet. Bei der Verwendung eines MOS-Feldeffekttransistors als Schalter $T_1$, $T_2$ kann auf eine Diode $D_1$, $D_2$ verzichtet werden, da MOS-Feldeffekttransistoren strukturbedingt eine integrierte Diode aufweisen. In diesem Fall wären externe Freilaufdioden $D_1$, $D_2$ optional.

Zwischen dem Mittelabgriff 3 und Masse ist parallel zum Schalter $T_2$ ein Umschwingkondensator $C_U$ angeordnet. Dieser kann jedoch auch alternativ oder auch zusätzlich zwischen dem Mittelabgriff 3 und dem ersten Anschluss 1 der Versorgungsspannungsquelle $U_B$ parallel zum Schalter $T_1$ angeordnet sein.

Parallel zum Umschwingkondensator $C_U$ und der Parallelschaltung aus dem zweiten Schalter $T_2$ und der Freilaufdiode $D_2$ ist eine Serienschaltung einer Induktivität L des piezoelektrischen Aktors P und eines Messwiderstandes $R_S$ angeordnet. Der Messwiderstand $R_S$ ist hierbei optional. Durch die Messung der über dem Widerstand $R_S$ abfallenden Spannung $V_{RS}$ lässt sich der durch die Spule L und den piezoelektrischen Aktor P fließende Strom $I_L$ berechnen,

Im Folgenden wird vereinfacht angenommen, dass die über dem Messwiderstand $R_S$ abfallende Spannung $V_{RS}$ so klein ist, dass die Spannung $V_{OUT}$ ungefähr gleich der über dem Aktor P abfallenden Spannung $V_{piezo}$ ist.

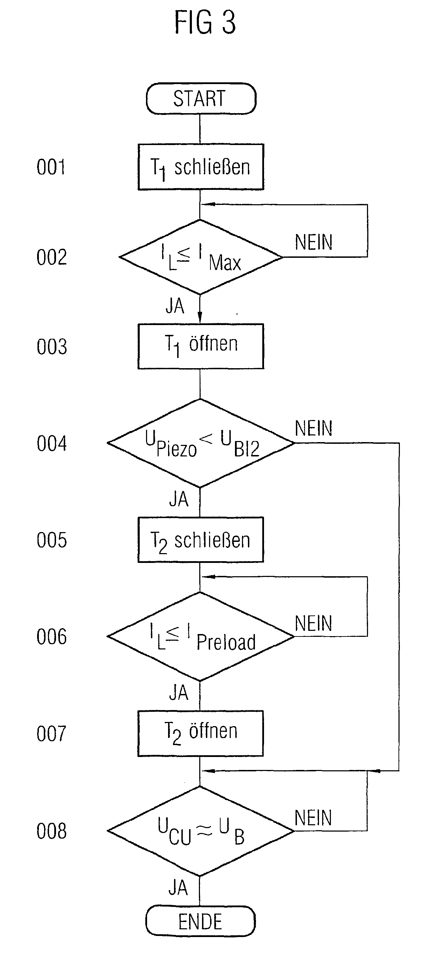

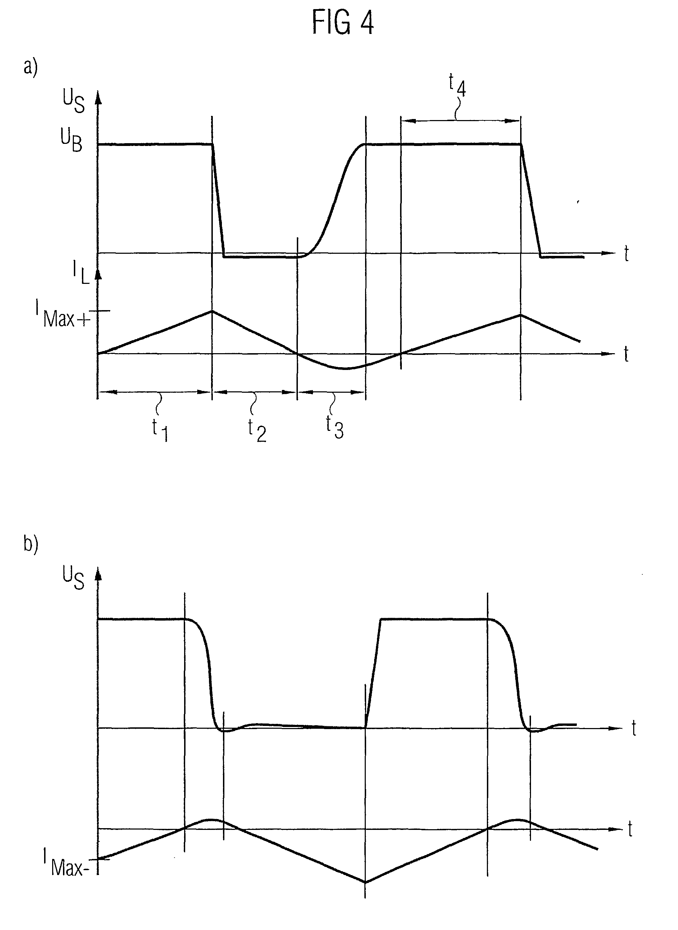

Ein Ladevorgang wird nun anhand des in Figur 3 dargestellten Ablaufdiagramms und den in der Figur 4a dargestellten Strom- und Spannungsverläufen näher erläutert.

Beim ersten Einschalten des Schalters T1 wird der Umschwingkondensator $C_U$ schnell aufgeladen. Der hierfür fließende Ladestrom spielt im Hinblick auf das EMV-Verhalten der Schaltungsanordnung nur eine untergeordnete Rolle.

Zu Beginn des Ladevorgangs wird der Schalter $T_1$ geschlossen (Schritt 001), wodurch der Mittelabgriff 3 der Brückenschaltung mit der Versorgungsspannung $V_{in}$ beaufschlagt wird. Ist nun die Spannung $V_{OUT}$ über dem piezoelektrischen Aktor P kleiner der Versorgungsspannung $V_{in}$, so fällt über der Induktivität L eine Spannung $V_L$ ab, die größer 0 ist. Der Strom $I_L$ durch die Spule L steigt somit linear an (Abschnitt $t_1$).

Erreicht der Strom $I_L$ durch die Spule L einen vorgegebenen Maximalwert $I_{max}$, so wird der Schalter $T_1$ geöffnet (Schritt 002 und Schritt 003). Das Öffnen und Schließen der Schalter $T_1$, $T_2$ erfolgt hierbei durch eine Steuer- und Überwachungsschaltung ST. Diese Steuerschaltung dient sowohl zum reproduzierbaren Auf- und Entladen des piezoelektrischen Aktors P, als auch zum Überwachen der unten näher erläuterten Umschwingbedingung. Die Steuerschaltung ST weist hier zwei Eingänge auf. Einen ersten zum Überwachen der Eingangsspannung $V_{in}$ des Spannungswandlers und einen zweiten zum Überwachen der Ausgangsspannung $V_{out}$. Die Stuereschaltung ST weist weiter zwei Ausgänge auf, wobei jeweils einer mit dem entsprechenden Steuereingang $G_{T1}$ bzw $G_{T2}$ der Schalter T1 und T2 verbunden ist.

Die über dem Schalter $T_1$ abfallende Spannung $V_{T1}$ entspricht der Versorgungsspannung $V_{in}$ minus der über dem Kondensator abfallenden Spannung $V_{CU}$. Da somit über dem Schalter $T_1$ eine geringere Spannung $V_{T1}$ abfällt, reduzieren sich auch die Schaltverluste am Schalter $T_1$. Der Umschwingkondensator $C_U$ ist so dimensioniert, dass die Entladezeit des Kondensators $C_U$ zumindest größer als die Abschaltzeit des Schalters $T_1$ ist. Der Wert der Kapazität des Umschwingkondensators $C_U$ bestimmt sich aus dem Strom beim Abschalten und dem hierbei erforderlichen Spannungshub $V_{in}$.

Der Abschaltvorgang des Schalters $T_1$ läuft somit im Vergleich zum Ansteigen der Spannung $V_{T1}$ schneller ab.

Im hier dargestellten Ausführungsbeispiel weist der Kondensator $C_U$ beispielsweise eine Kapazität von 10 nF und die Spule L eine Induktivität von 5 pH auf. Verglichen mit einem Schaltvorgang ohne Umschwingkondensator $C_U$ reduzieren sich die Schaltverluste in diesem Fall deutlich.

Der Kondensator $C_U$ entlädt sich nun über die Spule L, wodurch der piezoelektrische Aktor P weiter geladen wird. Der Umschwingkondensator $C_U$ wird komplett entladen. Dieser Entladevorgang benötigt im dargestellten Ausführungsbeispiel eine Zeitdauer von 200 bis 300 Nanosekunden.

Erreicht die Spannung $V_{CU}$ über dem Kondensator $C_U$ Null, so wird die Freilaufdiode $D_2$ leitend, wodurch die Spannung $V_{CU}$ über dem Kondensator $C_U$ leicht unter das Massepotential in Folge der Piezospannung $V_{piezo}$ abfällt. Während dieser Zeitdauer nimmt der Strom durch die Spule linear ab (Abschnitt t2)

Aufgrund der nun über der Spule L abfallenden negativen Spannung $V_{OUT}$ des piezoelektrischen Aktors P wird die Spule L wieder geladen. Die so der Spule L zugeführte Energie führt zu einer Resonanzumladung im durch Spule L und Umschwingkondensator $C_U$ gebildeten Serienschwingkreis. Die Spannung $V_{CU}$ über dem Kondensator $C_U$ steigt.

Hierbei bestimmt der Serienschwingkreis aus Umschwingkondensator $C_U$ und Spule L den Strom- und Spannungsverlauf. Die Spannung $C_U$ steigt s-förmig an, wobei der Strom $I_L$ von 0 ausgehend in Form einer negativen Sinushalbwelle verläuft (Abschnitt t3).

Für den Fall, dass $V_{OUT}$ größer der halben Versorgungsspannung Vin/2 ist, so wird der Umschwingkondensator $C_U$ wieder bis zur vollen Versorgungsspannung $V_{in}$ aufgeladen, wodurch die Freilaufdiode $D_1$ leitend wird.

Solange der Umschwingkondensator $C_U$ geladen und die über dem Kondensator $C_U$ abfallende Spannung gleich der Versorgungsspannung ist, kann der Schaltet $T_1$ nahezu unbelastet geschaltet werden. Hierdurch wird eine weitere Aufladephase t4 eingeleitet. Der Strom $I_L$ steigt wieder linear von 0 bis zu einem vorgegebenen Maximalwert an, bei dem der Schalter $T_1$ entsprechend der oben ausgeführten Beschreibung wieder geöffnet wird.

Für den Fall, dass vor dem Umschwingvorgang die Spannung $V_{OUT}$ über dem piezoelektrischen Aktor P kleiner der halben Versorgungsspannung $V_{in}$/2 ist, so ist die sog. Umschwingbedingung nicht erfüllt und es kommt zwar auch in diesem Fall zu einer Resonanzumladung am Kondensator $C_u$, jedoch würde dann ein solcher Ladevorgang nur zu einer maximalen Kondensatorspannung $V_{CU}$ von zwei mal $V_{OUT}$ führen. Da diese Spannung aufgrund der vorgegebenen Bedingung $V_{OUT}$ kleiner $V_{in}$/2 kleiner als die Betriebsspannung $V_{in}$ wäre, würde bei einem Schaltvorgang die Spannung

$$\Delta VS = V_{T1} = V_{in} - V_{CU} = V_{in} - 2\ V_{OUT}$$

über dem Schalter $T_1$ abfallen.

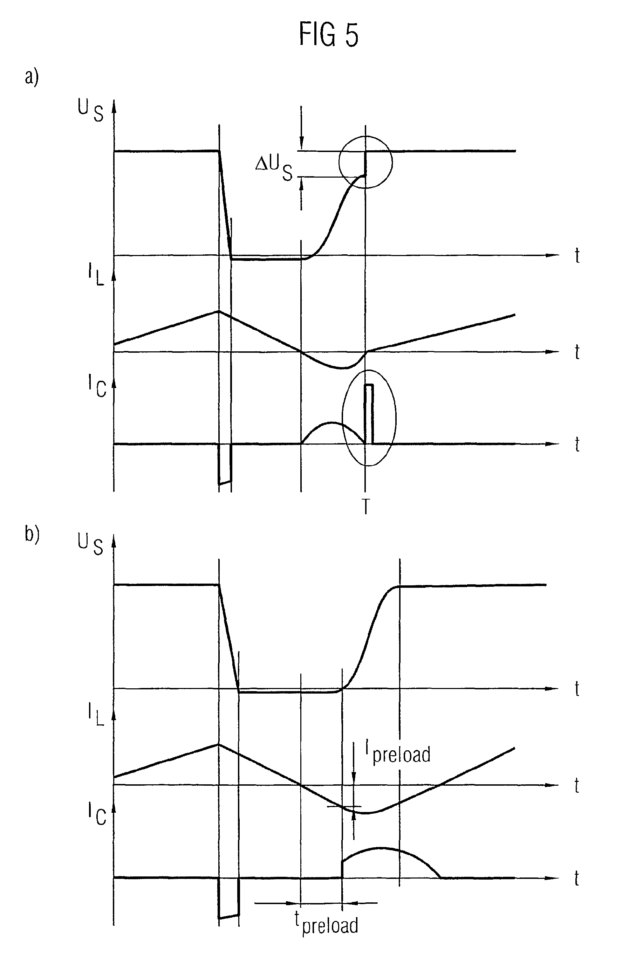

Wird der Schalter $T_1$ in diesem Fall eingeschaltet, so liegt die Spannung $VT_1$ am Schalter $T_1$ an. Dies führt zum einen zu Schaltverlusten und zum anderen zu einer sehr schnellen Aufladung des Umschwingkondensators $C_U$ und somit zu einer Stromspitze (vgl. Figur 5a). Zum einen verursacht diese Stromspitze wiederum hochfrequente elektromagnetische Störungen, zum anderen geht ein Teil der im Kondensator gespeicherten Restenergie $\Delta W = 1/2 \times \Delta VS^2 \times C_U$ verloren.

Um diesen Effekt zu verhindern wird nach dem Öffnen des Schalters $T_1$ die Spannung $V_{OUT}$ mit einem vorgegebenen Schwellwert $V_{in}$/2 verglichen (Schritt 004). Ist die Spannung $V_{OUT}$ größer als $V_{in}$/2, so läuft der Resonanzumschwingvorgang ohne weitere Eingriffe ab.

Ist jedoch die Ausgangsspannung $V_{OUT}$ kleiner als $V_{in}$/2, so wird der Schalter $T_2$ geschlossen und somit ein negativer Stromfluss $I_L$ vom piezoelektrischen Aktor P zur Spule L hin eingeleitet. Es wird dann so viel Energie in den Schwingkreis - in die Spule L -eingebracht, dass gewährleistet ist, dass bei einem Resonanzumschwingvorgang der Umschwingkondensator $C_u$ bis zur Versorgungsspannung $V_{in}$ geladen wird.

Als Maß hierfür dient der Strom $I_L$ durch die Spule L. In diesem Fall ist der Stromfluss entgegengesetzt zu der in Figur 2 dargestellten Richtung des Stroms $I_L$. Der Schalter $T_2$ wird geöffnet, sobald der Strom $I_L$ kleiner oder gleich einer vorbestimmten Schwelle $I_{preload}$ ist (Schritt 006 und Schritt 007). Der Schalter $T_2$ ist für eine Zeitdauer $t_{preload}$ geschlossen. Die in der Spule L gespeicherte Energie reicht nun aus, um den Kondensator $C_U$ auf die Spannung $V_{in}$ aufzuladen. Der Schalter $T_1$ kann im Anschluss daran mit vernachlässigbaren Schaltverlusten wieder eingeschaltet werden.

Hierdurch können die Quellen der Verlustleistung räumlich entzerrt werden, wodurch die thermische Belastung einzelner Bauteile verringert wird. In Folge dessen können Überlastungen durch Temperaturen die oberhalb des zulässigen Betriebsbereichs einzelner Bauteile liegen, verhindert werden. Diese Verlustleistungsverteilung führt zu einer zusätzlichen Kostenreduktion und macht eine weitere Miniaturisierung der Schaltungsanordnung möglich.

Der in Figur 4b dargestellte Entladevorgang läuft weitestgehend umgekehrt wie der in Figur 4a dargestellte Aufladevorgang ab. Die im Kondensator $C_U$ gespeicherte Energie entlädt sich hier ebenfalls wieder durch eine Resonanzumladung in die Spule L. Der Verlauf des Stroms $I_L$ ist hier wieder entsprechend sinusförmig, der Spannungsverlauf über dem Kondensator $C_U$ s-förmig. Sobald die Spannung $V_{CU}$ am Kondensator $C_U$ das Bezugspotential 0V erreicht, kann der Schalter $T_2$ verlustfrei geschaltet werden.

Durch Schließen des Schalters $T_2$ wird eine Reihenschaltung aus dem piezoelektrischen Aktor P und der Spule L gebildet, wodurch ein negativer Strom $I_L$ einen Teil der im piezoelektrischen Element P gespeicherten Energie in die Spule L überführt. Wird nun ein vorgegebener maximaler Entladestrom $I_{MAX}$ detektiert, so wird der Schalter $T_2$ wieder geöffnet. Die Spannung $V_{CU}$ über dem Umschwingkondensator $C_U$ ist zu diesem Zeitpunkt immer noch O, wodurch ein verlustfreies Schalten des Schalters $T_2$ ermöglicht wird.

Nach dem Öffnen des Schalters $T_2$ wird zum einen der Kondensator $C_U$ durch die in der Spule L gespeicherte Energie aufgeladen und zum anderen erfolgt ein Stromfluss über die Diode $D_1$ zum Ladekondensator $C_L$ hin, wodurch die in der Spule L gespeicherte Energie in den Kondensator $C_L$ zurückgespeist wird. Erreicht der Spulenstrom $I_L$ den Wert 0, so entlädt sich die im Kondensator $C_U$ gespeicherte Energie wieder in die Spule L. Die Spannung $V_{CU}$ über dem Kondensator $C_U$ fällt s-förmig bis zum Erreichen von 0V ab. Dadurch, dass die Freilaufdiode $D_2$ nun leitend wird sinkt die Spannung $V_{CU}$ über den Kondensator bis leicht unter das Massepotential ab. Zu diesem Zeitpunkt kann der Schalter $T_2$ nahezu verlustfrei wieder eingeschaltet werden und so ein Umladen der im piezoelektrischen Aktor P gespeicherten Energie in die Spule L ermöglicht werden.

Die Figuren 5a und 5b zeigen einen Aufladevorgang für eine Ausgangsspannung $V_{OUT}$ kleiner $V_{in}$/2. Im Falle

des Aufladens ohne Vorladen (Figur 5a) erreicht die Kondensatorspannung $V_{CU}$ durch die Resonanzumladung nur den doppelten Wert von $V_{OUT}$, wodurch beim Einschalten der bereits beschriebene Spannungssprung auftritt.

Figur 5b zeigt einen entsprechenden Aufladevorgang mit einer Vorladung. Hier kommt es durch Schließen des Schalters $T_2$ und der damit verbundenen Vorladung der Spule L zu einer vollständigen resonanzbedingten Aufladung des Kondensators $C_U$. Dadurch wird die Stromspitze vermieden. Auch wird somit - wie bereits beschrieben - die Restenergie im Kondensator $C_U$ nicht vernichtet und dadurch ein Aussenden hochfrequenter elektromagnetischer Störung verhindert.

Für den Fall, dass beim Entladen die Piezospannung $V_{OUT}$ größer der halben Versorgungsspannung $V_{in}/2$ ist, kann entsprechend ebenfalls ein Vorladen der Spule L erfolgen.

Der Wert des Vorladestroms $I_{preload}$ ist sowohl beim Laden als auch beim Entladen von der Spannung $V_{OUT}$ abhängig. Für das Laden ist $I_{preload}$ für eine Ausgangsspannung von $V_{OUT} = 0$ maximal und sinkt kontinuierlich bis auf den Wert 0 ab. Der Wert 0 für den Vorladestrom wird erreicht, wenn $V_{OUT}$ größer $V_{in}/2$ ist. Entsprechend gilt beim Entladen: $I_{preload}$ ist maximal für $V_{OUT} = Vi_n$. $I_{preload}$ sinkt kontinuierlich bis zum Wert 0 ab und erreicht den Wert 0 für $V_{OUT}$ kleiner gleich $V_{in}/2$.

Sowohl der Wert des Stroms $I_L$ durch die Spule L, als auch der Vorladestrom $I_{preload}$ können von einer hier nicht dargestellten Steuerschaltung durch Messen der Spannung über den Messwiderstand $R_S$ ermittelt werden.

## Patentansprüche

1. Spannungswandler zum Ansteuern einer kapazitiven Last (P), der aufweist:

   - eine Induktivität (L), über welche die Last (P) durch Resonanzumladungsvorgänge geladen und entladen wird,
   - einen ersten Schalter ($T_1$) und einen zweiten Schalter ($T_2$), die zum Zuführen bzw. Abführen von Energie zu bzw. von der Induktivität (L) dienen,
   - zumindest einen Umschwingkondensator ($C_U$), der einem der beiden Schalter ($T_1$, $T_2$) parallel geschaltet ist, wobei die über dem Umschwingkondensator ($C_U$) abfallende Spannung ($V_{CU}$) die Spannung über dem Schalter ($T_1$, $T_2$) während eines Schaltvorgangs reduziert, und
   - eine Steuereinheit (ST), die die Ausgangsspannung ($V_{out}$) und/oder die Versorgungsspannung ($V_{in}$) des Span-nungswandlers überwacht und in Abhängigkeit von zumindest einer dieser Spannungen ($Vi_n$, $V_{out}$) die Schalter ($T_1$, $T_2$) zur Realisierung der Resonanzumladungsvorgänge ansteuert,

   wobei die beiden Schalter ($T_1$, $T_2$) eine Halbbrücke bilden, die zwischen den Versorgungsanschlüssen (1, 2) einer Versorgungsspannungsquelle ($U_B$) angeordnet sind und deren Mittelabgriff (3) einerseits mit einem Anschluss des Umschwingkondensators ($C_U$) und andererseits über die Induktivität (L) mit der Last (P) elektrisch verbunden ist, und wobei die Steuereinheit (ST) dazu ausgebildet ist, durch Ansteuern eines der beiden Schalter ($T_1$, $T_2$) der Induktivität (L) zusätzlich Energie zuzuführen, falls die in der Induktivität (L) gespeicherte Energie nicht ausreicht, um den Umschwingkondensator ($C_U$) durch eine nachfolgende Resonanzumladung auf eine Spannung aufzuladen, die in etwa der Versorgungsspannung ($V_{in}$) entspricht.

2. Spannungswandler nach Anspruch 1, **dadurch gekennzeichnet, dass** die Kapazität des Umschwingkondensators ($C_U$) so bemessen ist, dass dessen Entladezeit zumindest der Schaltzeit der Schalter ($T_1$, $T_2$) entspricht.

3. Spannungswandler nach Anspruch 1 oder 2, **dadurch gekennzeichnet, dass** die Schalter ($T_1$, $T_2$) in Abhängigkeit von einem Strom ($I_L$ durch die Induktivität (L) oder die Last (P) gesteuert werden.

4. Spannungswandler nach einem der vorangehenden Ansprüche, **dadurch gekennzeichnet, dass** die Schalter ($T_1$, $T_2$) in Abhängigkeit von einer Spannung ($V_L$, $V_{out}$), die über der Induktivität (L) oder der Last (P) abfällt, gesteuert werden.

## Claims

1. Voltage transformer for activating a capacitive load (P), which comprises:

   - an inductor (L), by way of which the load (P) is charged and discharged by means of resonance charge exchange processes,
   - a first switch ($T_1$) and a second switch ($T_2$) which are used to supply and/or discharge energy to and/or from the inductor (L),

- at least one polarity-reversing capacitor ($C_U$) which is connected in parallel to one of the two switches ($T_1$, $T_2$), whereby the voltage ($V_{CU}$) dropping across the polarity-reversing capacitor ($C_U$) reduces the voltage across the switches ($T_1$, $T_2$) during a switching process, and

- a control unit (ST), which monitors the output voltage ($V_{out}$) and/or the supply voltage ($V_{in}$) of the voltage converter and activates the switches ($T_1$, $T_2$) in order to realise the resonance charge exchange processes as a function of at least one of these voltages ($V_{in}$, $V_{out}$)

- with the two switches ($T_1$, $T_2$) forming a half-bridge, which are arranged between the power supplies (1, 2) of a power supply source ($U_B$) and the centre tap (3) of which is electrically connected on the one hand to a terminal of the polarity-reversing capacitor ($C_U$) and on the other hand via the inductor (L) to the load (P),

- and with the control unit (ST) being embodied to supply additional energy to the inductor (L) by activating one of the two switches ($T_1$, $T_2$) if the energy stored in the inductor (L) is not sufficient to charge the polarity-reversing capacitor to a voltage by means of a subsequent resonance charge exchange, said voltage approximately corresponding to the supply voltage ($V_{in}$).

2. Voltage transformer according to claim 1, **characterized in that** the capacity of the polarity-reversing capacitor ($C_U$) is measured such that its discharging time corresponds at least to the switching time of the switches ($T_1$, $T_2$),

3. Voltage transformer according to claim 1 or 2, **characterized in that** the switches ($T_1$, $T_2$) are controlled by the inductor (L) or the load (P) as a function of a current ($I_L$).

4. Voltage transformer according to one of the preceding claims, **characterized in that** the switches ($T_1$, $T_2$) are controlled as a function of a voltage ($V_L$, $V_{out}$), which drops across the inductor (L) or the load (P).

**Revendications**

1. Convertisseur de tension destiné à commander une charge capacitive (P), qui comprend :

- une inductance (L) par l'intermédiaire de laquelle la charge (P) peut être chargée et déchargée par des processus de transfert de charge à résonance,

- un premier interrupteur ($T_1$) et un deuxième interrupteur ($T_2$) qui servent à amener respectivement à évacuer de l'énergie à respectivement de l'inductance (L),

- au moins un condensateur d'oscillation ($C_U$) qui est connecté en parallèle avec l'un des interrupteurs ($T_1$, $T_2$), la tension ($V_{CU}$) qui chute entre les bornes du condensateur d'oscillation ($C_U$) réduisant la tension entre les bornes de l'interrupteur ($T_1$, $T_2$) pendant un processus de commutation, et

- une unité de commande (ST.) qui surveille la tension de sortie ($V_{out}$) et/ou la tension d'alimentation ($V_{in}$) du convertisseur de tension et qui, en fonction d'au moins une de ces tensions ($V_{in}$, $V_{out}$), commande les interrupteurs ($T_1$, $T_2$) pour la réalisation des processus de transfert de charge à résonance,

dans lequel les deux interrupteurs ($T_1$, $T_2$) forment des demi-ponts qui sont disposés entre les connexions d'alimentation (1, 2) d'une source de tension d'alimentation ($U_B$) et dont la prise centrale (3) est reliée électriquement, d'une part, à une connexion du condensateur d'oscillation ($C_U$) et, d'autre part, par l'intermédiaire de l'inductance (L), à la charge (P).

et dans lequel l'unité de commande (ST) est configurée de façon à amener de l'énergie en supplément à l'inductance (L), par commande d'un des deux interrupteurs ($T_1$, $T_2$), dans le cas où l'énergie accumulée dans l'inductance (L) ne suffit par pour charger le condensateur d'oscillation ($C_U$), par un transfert de charge à résonance suivant, à une tension qui correspond à peu près à la tension d'alimentation ($V_{in}$).

2. Convertisseur de tension selon la revendication 1, **caractérisé en ce que** la capacité du condensateur d'oscillation ($C_U$) est dimensionnée de manière que son temps de décharge corresponde au moins au temps de commutation des interrupteurs ($T_1$, $T_2$) .

3. Convertisseur de tension selon la revendication 1 ou 2, **caractérisé en ce que** les interrupteurs ($T_1$, $T_2$) sont commandés en fonction d'un courant ($I_L$) qui traverse l'inductance (L) ou la charge (P).

4. Convertisseur de tension selon une des revendications précédentes, **caractérisé en ce que** les interrupteurs ($T_1$, $T_2$) sont commandés en fonction d'une tension ($V_L$, $V_{out}$) qui chute entre les bornes de l'inductance (L) ou de la charge (P). Je ne suis pas sûr de mon vocabulaire. Ma traduction demandera à être révisée.

# FIG 1

# FIG 2

EP 1 683 254 B1

# FIG 3

START

001    $T_1$ schließen

002    $I_L \leq I_{Max}$    NEIN

JA

003    $T_1$ öffnen

004    $U_{Piezo} < U_{Bl2}$    NEIN

JA

005    $T_2$ schließen

006    $I_L \leq I_{Preload}$    NEIN

JA

007    $T_2$ öffnen

008    $U_{CU} \approx U_B$    NEIN

JA

ENDE

# FIG 4

a)

b)

# FIG 5

a)

b)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19944733 A1

- US 5594635 A

**In der Beschreibung aufgeführte Nicht-Patentliteratur**

- **MUHAMMAD H. RASHID.** Power Electronics Circuits, Devices and Applications. Pearson Education, 2004